# Europäisches Patentamt

## European Patent Office

## Office européen des brevets

(19)

(11) Publication number: **0 081 484**

**B1**

(12) # EUROPEAN PATENT SPECIFICATION

(45) Date of publication of patent specification: **20.11.86**

(51) Int. Cl.⁴: **H 01 R 13/62**

(21) Application number: **81901843.3**

(22) Date of filing: **27.05.81**

(86) International application number:
**PCT/US81/00706**

(87) International publication number:
**WO 82/04359 09.12.82 Gazette 82/29**

(54) INTEGRATED CIRCUIT PACKAGE WITH BATTERY HOUSING.

| | |
|---|---|
| (43) Date of publication of application:<br>**22.06.83 Bulletin 83/25** | (73) Proprietor: **MOSTEK CORPORATION**<br>**1215 West Crosby Road**<br>**Carrollton, TX 75006 (US)** |
| (45) Publication of the grant of the patent:<br>**20.11.86 Bulletin 86/47** | (72) Inventor: **LINK, Joseph**<br>**1802 Kensington Drive**<br>**Carrollton, TX 75007 (US)**<br>Inventor: **BOLAN, Michael Louis**<br>**6214 Misty Trail** |
| (84) Designated Contracting States:<br>**DE FR GB NL** | **Dallas, TX 75248 (US)**<br>Inventor: **BRUNK, Allen Hendrix, Jr.**<br>**3015 Country Square Drive No. 2144**<br>**Carrollton, TX 75006 (US)**<br>Inventor: **SCHNEIKART, Paul Edward** |
| (56) References cited:<br>EP-A-0 024 364<br>DE-A-2 752 385<br>GB-A-2 039 687<br>US-A-2 782 389<br>US-A-3 289 045 | **521 Medina Drive**<br>**Lewisville, TX 75067 (US)** |
| US-A-3 575 678<br>US-A-3 634 600<br>US-A-3 984 257<br>US-A-4 053 688<br>US-A-4 245 877 | (74) Representative: **UEXKÜLL & STOLBERG**<br>**Patentanwälte**<br>**Beselerstrasse 4**<br>**D-2000 Hamburg 52 (DE)** |
| SCHMUCK UND UHREN, no. 23/24, December<br>1980, ULM/DONAU (DE) G. GLASER et al.:<br>"Uhrentechnik" | |

## Description

The present invention pertains to integrated circuits and the packages therefore and more particularly to a package for housing a battery to sustain data states in volatile semiconductor memories.

There are many applications involving integrated circuits and in particular integrated circuit memories in which it is desirable to maintain power to the circuit at all times to sustain data states which are stored in the circuit. When power is removed from the circuit critical parameters are often lost due to the volatile memory. In many applications it is necessary to reload these parameters before operation can be continued.

GB—A—2 039 687 discloses a battery case having at least two terminal pins which extend through the battery case for insertion into a mating socket for an integrated circuit. The socket is a DIP socket which allows for easy and cost-effective assembling of a battery to a printed circuit board.

It is an object of this invention to provide for a reliable battery back-up to an integrated circuit, particularly to a memory chip with minimum space requirements.

This object is achieved by an apparatus for use in conjunction with an integrated circuit adapted for communication with external components, comprising a package having means for communication between the integrated circuit and external components; means for securing one battery to said package and electrical conduction means extending from said means for securing to said integrated circuit for providing power from the battery to the integrated circuit. The apparatus is characterized in that said package houses said integrated circuit and that said means for securing comprises structure connected to said package, said structure having one or more recesses each adapted to receive a battery and clip means connected to said structure and extending in a spaced relationship to said recess for securing a battery in each recess.

A further object of this invention is to provide for a method of constructing an apparatus for a reliable battery back-up to an integrated circuit, particularly to a memory chip with minimum space requirements.

This object is achieved by the features of Claim 7.

Advantageous further embodiments of the invention as claimed in Claims 1 and 7 are characterized in Sub-claims 2—6 or 8—10.

US—A—4 053 688 discloses a battery holder for a wrist watch but does not teach to combine a battery with an integrated circuit in a manner that the battery is inserted into the housing of an IC.

For a more complete understanding of the present invention and the advantages thereof, reference is now made to the following description taken in conjunction with the accompanying drawings in which:

FIGURE 1 is an exploded view of a structure for housing a plurality of batteries which are connected to an integrated circuit within an adjacent package and the batteries:

FIGURE 1A is a detail of an alternate end for the spring clips used in the present invention;

FIGURE 2 is a partial cross-section elevation view of the integrated circuit package and the structure for receiving batteries;

FIGURE 3 is a partial cross-section plan view of the structure illustrated in FIGURE 2 with the batteries and upper clip removed therefrom to better illustrate the underlying structure; and

FIGURE 4 is a plan view of a lead frame for use in the integrated circuit package.

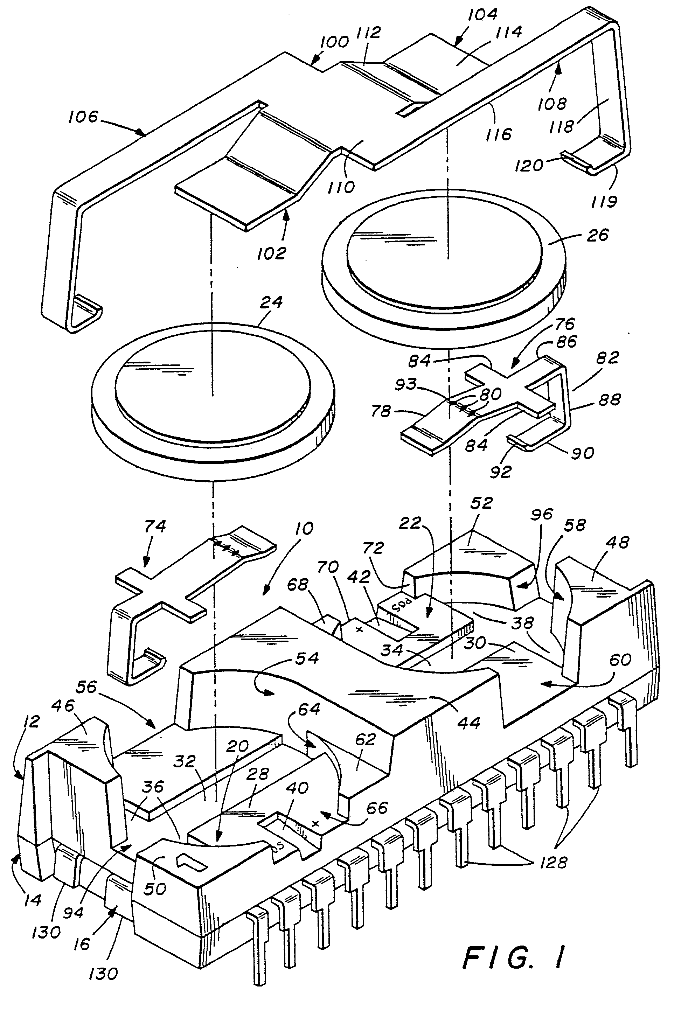

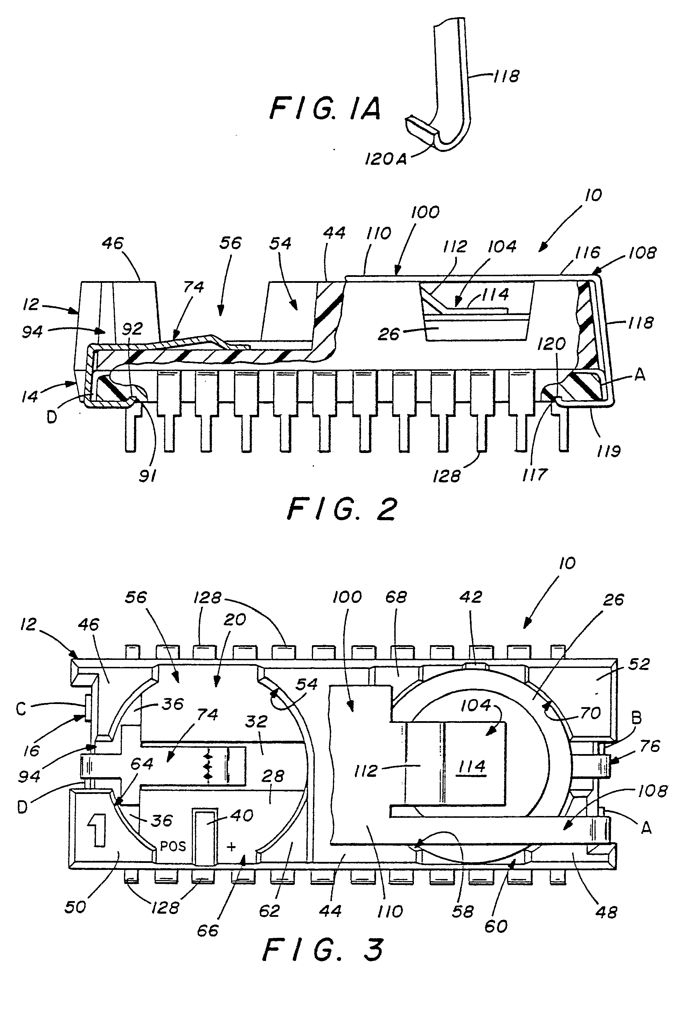

A first embodiment of the present invention is illustrated generally by the reference numeral 10 in FIGURE 1. The apparatus 10 includes a rectangular structure 12 which is generally disposed above a dual in-line integrated circuit package 14. The package 14 includes an integrated circuit which communicates with external components through lead frame 16 having leads forming pins and tabs. The lead frame 16 described hereinafter and illustrated in the figures has 24 pins and 3 tabs provided for communication with the integrated circuit. However, the number of leads may vary with the application in which the integrated circuit is to be used.

Recesses 20 and 22 are formed in the upper surface of the structure 12. These recesses are shaped to receive batteries 24 and 26.

Each recess 20 and 22 includes a bottom portion 28 and 30, respectively. The underside of each battery 24 and 26 rests on the bottom portion 28 and 30 as best shown in FIGURE 2. Each bottom portion includes an elongate notch 32 or 34 which extends below the plane of the bottom portion. The notch 32 includes arms 36 at the outer portion thereof which include an arcuate portion as best seen in FIGURE 3. Notch 34 similarly includes arms 38. Inclined notches 40 and 42 are also formed in the bottom portions. The notches are inclined upwardly towards the center of the bottom portions.

A central dividing member 44 extends upward between the bottom portions. Wall end members 46 and 48 extend upwardly from opposed corners of the structure 12. Lip end members 50 and 52 extend upwardly at the opposite opposed corners of structure 12.

Central dividing member 44 and wall end member 46 define a semi-circular wall 54 surrounding the bottom portion 28. The wall portion is broken by a slot 56 formed between the members 44 and 46. A similar semi-circular wall portion 58 is defined by the members 44 and 48. The portion 48 is broken by slot 60.

The central dividing member 44 includes an extension 62 which defines a semi-circular lip 64 with the lip end member 50. The lip is broken by a slot 66 between the extension 62 and member 50. A similar extension 68 defines lip 70 between the extension and member 52. A slot 72 interrupts the lip between the extension and member.

Bottom spring clips 74 and 76 are positioned within the notches 32 and 34, respectively. Each of the clips 74 and 76 is identical. Therefore, only clip 76 will be described in detail. The clip 76 is formed of a resilient conductor material. The clip includes a battery contact portion 78 having one or more point contacts 80 thereon. The point contacts are designed to provide enhanced ohmic contact with the lower terminal of the battery, i.e. lessen contact resistance.

The clip 76 also includes a fastener portion 82. The fastener portion 82 includes tabs 84, an outwardly extending horizontal piece 86, a downwardly extending vertical piece 88, and an inwardly extending horizontal piece 90. The free end of piece 90 includes an up-turned end 92.

The clips 74 and 76 are mounted in the structure 12 as shown in FIGURES 1—3. The battery contact portion 78 of the clips extend along the notches 32 and 34 with the point contacts 80 centered within the bottom portions. The tabs 84 of clips 74 and 76 extend into the arms 36 and 38, respectively. The pieces 86 extend through slots 94 and 96 in structure 12 and the pieces 88 and 90 extend downwardly and inwardly into contact with individual leads on lead frame 16. The pieces 90 extend inwardly below the package 14 and the ends 92 are preferably received within the notches 91 formed in the bottom of the package 14.

It is apparent that the configuration of the clips 74 and 76 will maintain the clips secured to the apparatus 10. The clips are designed so that the point contacts 80 extend above the plane defined by the bottom portions 28 and 30 when non-deformed. A camber 93 in the battery contact portions 78 along the line of contacts 80 insure the contacts project furthest above the bottom portions. In the preferred embodiment, the fastener portions 82 of the clips are also soldered to the lead frame to prevent removal of the clips and insure a positive electrical connection.

A top spring 100 is provided. The spring clip includes battery contact portions 102 and 104 and fastener portions 106 and 108. The clip 100 is preferably formed from an integral piece of a flexible, conductive material.

The battery contact portions 102 and 104 include a common center 110 and each include a downwardly inclined piece 112 and a horizontal piece 114. The fastener portions 106 and 108 include outwardly extending horizontal pieces 116, vertically downward extending pieces 118 and inwardly extending pieces 119 terminating in upwardly curved ends 120.

The top spring clip 100 extends over the structure 12 and the pieces 118 and 119 of the fastening portions and ends 120 retain the clip secured to structure 12. Again, recesses 117 may be provided in the package 14 to accept ends 120. An alternate end 120A shown in FIGURE 1A may be substituted for pieces 90 and 119 and ends 92 and 120. The end 120A includes a curved portion of constant radius. Portions of pieces 118 and 119 of each fastener portion 106 and 108 are in physical and electrical contact with leads on lead frame 16. In the preferred embodiment, the fastener portions are soldered to the frame to prevent disengagement of the clip and insure electrical contact.

In operation, the batteries 24 and 26 may be inserted within the apparatus 10 by sliding the batteries over the extensions 62 and 68 and lip end members 50 and 52 for their respective recesses. The placement of the batteries may be determined by a positive sign or language stamped on apparatus 10 as shown. The batteries are tilted to deflect the battery contact portions of the top spring clip upward and the battery contact portions of the bottom spring clips downwardly into their respective notches to permit the batteries to be seated within the recesses.

Once positioned as shown in FIGURES 2 and 3, the batteries are confined within the recesses by the lips 64 and 70, wall portions 54 and 58 and the battery contact portions of the bottom and top spring clips. The top spring clip 100 is designed to exert a downward force on the batteries through the battery contact portions 102 and 104 exceeding the upward force of the battery contact portions 78 of the bottom spring clips. The excess force is designed to retain the batteries in contact with the bottom portions during the worst shock loading for which the apparatus 10 is designed.

The force exerted by the battery contact portions 78 of the bottom spring clips is sufficient to insure adequate electrical contact between the point contacts 80 and the lower terminal of the batteries. The force exerted by the battery contact portions 102 and 104 of the top spring clip also provide electrical contact between the top spring clip and the upper terminal of the batteries. It is clear from Figures 1 and 3 that the upper terminals of the batteries are common and may be connected through the top spring clip 100 to the integrated circuit and one or more pins 18. The lower terminal of each battery may be connected to individual or common leads on lead frame 16 leading to the integrated circuit.

In a typical application, an integrated circuit static memory will be included in the package 14. The integrated circuit is utilized in such a manner that it is necessary to retain the data states stored in the memory even if power is lost to the memory. The batteries 24 and 26 may be connected in parallel through circuitry (not shown) which automatically connects the integrated circuit within the package 14 to either one or both of the batteries upon detection of loss of external power. Two batteries are utilized to improve reliability and to extend the length of time that the data can be stored. The interfacing circuitry between the batteries and the integrated circuit is designed to switch between the best of the two batteries and thereby provide the maximum possible data retention time. The batteries may be connected in series if a high voltage source is needed for a particular application.

If one of the batteries fails, it may be removed independently of the other battery. A thin non-conductive implement may be guided into contact with the battery to be removed through its associated inclined notch 40 or 42. A non-conductive implement is preferred to eliminate the potential for shorting the other battery or damaging the integrated circuit. Urging the implement into contact with the battery tilts the portion of the battery adjacent to the lip upward to permit its removal. If difficulty is encountered, an implement may be inserted through the slot 56 or 60 adjacent to the battery to push the battery from the recess.

The present invention provides several additional significant advantages. The batteries may be inserted or replaced in the apparatus 10 without removal of the apparatus from a printed circuit board or socket. Each of the batteries may be inserted or removed independently of the other battery so that the integrated circuit may be maintained in an active state continuously. The spring clips are securely, if not permanently, secured to the apparatus 10 which prevents loss of the clips during battery insertion or removal. The top spring clip 100 is the only spring exposed to operator induced stresses. The stress on the bottom spring clips does not exceed the stress necessary to urge the clips downward to permit the insertion of the batteries. Therefore, the provision of the stronger spring in the top spring clip reduces the potential for spring overstress. One or more of the spring clips may be connected to pins leading to externals. The externals may provide a trickle charge to retain the batteries in a charged state.

A suggested battery for use in this application is a Model CR—1220 lithium battery manufactured by Sanyo Electric Trading Co., Ltd. of Osaka, Japan. This battery produces a nominal 3.0 volts, has a capacity of 30 mah, a diameter of 12.5 millimeters, a thickness of 2.0 millimeters, a weight of .8 grams and can function over the temperature range of −20°C to +50°C.

In one apparatus constructed from the teaching of the present invention, the apparatus was adapted to receive batteries having a thickness of approximately 78 millimeters. In the constructed apparatus, lips 64 and 70 were designed to have a vertical height of 40 to 50 millimeters and the wall portions 54 and 58 a vertical height of 90 millimeters. The downward force exerted on the battery by the top spring clip 100 in the constructed apparatus was designed to be 1500 grams and the upward spring force exerted by the bottom spring clip on the batteries was designed to be 250 grams, a ratio of 6 to 1. The clips in this constructed apparatus were constructed of berylium copper. This material is designed to retain resiliency across the full semi-conductor temperature range. Phosphor bronze may also be employed as the spring clip material in lower temperature applications.

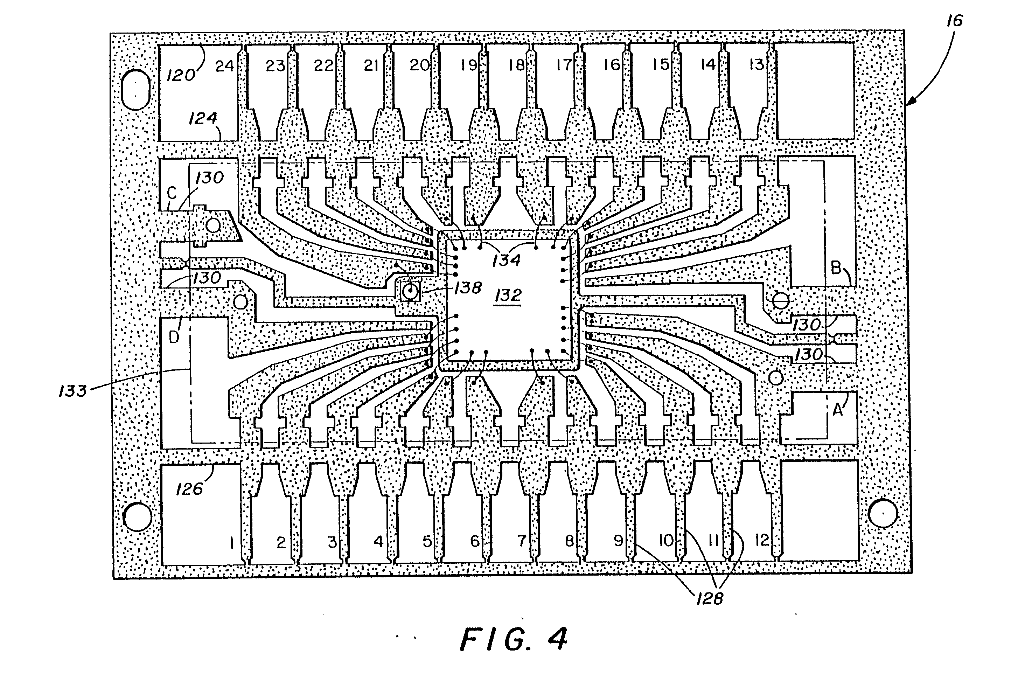

The detail of lead frame 16 is illustrated in FIGURE 4. The lead frame 16 is formed in several stages. The first stage comprises the stamping of the shape shown in FIGURE 4 in a coductive material. The body, comprising structure 12 and package 14 may then be molded about the lead frame 16 and CMOS 132. The outside limit of the body is shown by dotted line 133. The body is commonly formed of a plastic. In subsequent steps, the rail 120 is removed and the tie bars 124 and 126 are separated between each pin 128 and tab 130 to form independent leads to the integrated circuit, in this example a CMOS 132. Portions of the pins 128 and tabs 130 extend exterior of the plastic body forming the structure and package.

Twenty four individual pins 128 are provided on the frame 16 for contact with externals. The pins are numbered by convention from 1 to 24 beginning at the lower left pin in FIGURE 4 and proceding counterclockwise about the frame. Four tabs 130 are provided and are identified by letters A—D. Each pin and tab contacts terminals in CMOS 132 through small wires 134 bonded between the pins and tabs and contact pads 136 on CMOS 132.

Pin 12 and tab A form one conductor which acts as a common. One end of top spring clip 100 may be in contact with tab A. The opposite end of clip 100 may be secured to tab C, which has no electrical connection to the integrated circuit but aids in the retention of the clip 100 on the apparatus 10. If the batteries are positioned with their respective terminals in contact with top spring clip 100, the common will be the negative terminal. The wires 134 are employed for connection to CMOS 132 as the current flow at this location may be large.

Tabs B and D are positioned for contact with bottom spring clips 74 and 76. Power for operating CMOS 132 from an external source will be connected to pin 24. A diode 138 is provided to permit external power to flow to the CMOS 132 while blocking flow to the batteries. If the external power is lost, the diode permits energy to flow from the batteries to power the CMOS 132. With diode 138, the batteries cannot be charged by an external power source. However, the design of a circuit permitting the charging of the batteries would be obvious to one skilled in the art.

While apparatus 10 forms one embodiment of the present invention, it will be understood that the shape of the apparatus is related closely to the shape and type of battery employed. For example, the Model BR435 battery manufactured by Matsushita Electric Industrial Company, Ltd. of Japan has an overall tubular shape with the negative terminal formed by a pin extending from one end of the tubular portion and the positive terminal formed by an annular ring adjacent the pin. The apparatus 10 would be modified to accept the tubular shape and clips 74, 76 and 100 modified to contact the terminals and secure the batteries in place in the apparatus.

It will also be understood that the clips may extend to any portion of the apparatus desired. For example, the clips may extend on the side of apparatus 10 to contact one or more pins 128 in the lead frame 16. In addition structure 12 may be secured or mounted to package 14 in any suitable manner.

In summary the present invention comprises an apparatus to house one or more batteries in conjunction with a packaged integrated circuit. The batteries in the housing are connected such that data stored in the integrated circuit is retained for an extended period of time without external power or the operation of the integrated circuit can continue for an extended period of time without external power.

**Claims**

1. Apparatus for use in conjunction with an integrated circuit adapted for communication with external components, comprising;

a package (14) having means for communication between the integrated circuit (132) and external components:

means (100; 74; 76) for securing one battery (24; 26) to said package (14); and

electrical conduction means extending from said means (100; 74; 76) for securing to said integrated circuit (132) for providing power from the battery (24; 26) to the integrated circuit (132),

characterized in that said package (14) houses said integrated integrated circuit (132) and that said means (100; 74; 76) for securing comprises structure (12) connected to said package (14), said structure (12) having one or more recesses (20; 22) each adapted to receive a battery (24; 26) and clip means (100; 74; 76) connected to said structure (12) and extending in a spaced relationship to said recesses (20; 22) for securing a battery (24; 26) in each recess (20; 22).

2. Apparatus as recited in Claim 1 wherein said electrical conduction means includes two electrical conductors (134) extending to pins on said package (14) for communication with externals.

3. Apparatus as recited in Claim 1 wherein said means for securing permits positioning and removal of a battery (24; 26) to said package (14).

4. Apparatus as recited in Claim 3 wherein said means (100; 74; 76) for securing permits positioning and removal of each battery (24; 26) individually.

5. Apparatus as recited in Claim 1 wherein said recesses (20; 22) each include a lip (64; 70) for permitting the batteries (24; 26) to be positioned in and removed from said recess (20; 22) over the lip (64; 70).

6. Apparatus as recited in Claim 1 wherein said clip means (100; 74; 76) forms an electrical conductor and contacts a terminal on the battery (24; 26) upon securing the battery (24; 26) in the recess (20; 22).

7. A method of constructing an apparatus for use in conjunction with an integrated circuit adapted for communication with external components, comprising the steps of;

providing a package having means for communication between the integrated circuit and external components;

securing at least one battery in structure secured to said package, and

electrically interconnecting said integrated circuit and said battery by electrical conduction means;

characterized by the steps of:

mounting said integrated circuit in said package;

forming at least one recess in said structure adapted to receive a battery; and

securing said first clip means to said structure extending in a spaced relationship to said recess for securing a battery in the recess.

8. The method of Claim 7 further comprising the step of securing second clip means to said structure within the recess, said first and second clip means contacting the terminals of the battery for conducting power from the battery to the integrated circuit.

9. The method of Claim 7 further comprising the steps of:

forming a lip at the recess in said structure, said first clip means being formed of a fexible material to permit the battery to be positioned in and removed from said recess over the lip.

10. The method of Claim 7 further comprising the steps of:

mounting external electrical conduction means to said structure extending from said battery and said integrated circuit for connection to a source of external power; and

mounting diode means in said package to prevent current flow to said battery when external power is applied to power said integrated circuit and permit current to flow from said battery to said integrated circuit upon removal of the external power.

**Patentansprüche**

1. Vorrichtung zur Verwendung in Verbindung mit einer integrierten Schaltung, die zur Kummunikation mit externen Komponenten gestaltet ist, mit:

— einem Gehäuse (14), das Mittel zur Kommunikation zwischen der integrierten Schaltung (132) und externen Bauteilen aufweist;

— Mitteln (100; 74; 76) zum Befestigen einer Batterie (24; 26) an dem Gehäuse (14); und

— elektrischen Leitungsmitteln, die sich von den Mitteln (100; 74; 76) für die Befestigung an der integrierten Schaltung (132) erstrecken, um Strom von der Batterie (24; 26) zu der integrierten Schaltung (132) zu leiten:

dadurch gekennzeichnet, daß das Gehäuse (14) die integrierte Schaltung (132) enthält; daß die Mittel (100; 74; 76) zum Befestigen mit dem Gehäuse (14) verbundene Teile (12) aufweisen, die eine oder mehrere Vertiefungen (20; 22) besitzen, die jeweils zur Aufnahme einer Batterie (24; 26) geeignet sind; und daß Klammern (100; 74; 76) mit dem Teil (12) verbunden sind und sich im Abstand zu den Vertiefungen (20; 22) erstrecken, um eine Batterie (24; 26) in jeder Vertiefung (20; 22) zu befestigen.

2. Vorrichtung nach Anspruch 1, dadurch gekennzeichnet, daß die elektrischen Leitungsmittel zwei elektrische Leitern (134) aufweisen, die sich zu Klemmen erstrecken, die sich an dem Gehäuse (14) zur Kommunikation mit äußeren Teilen befinden.

3. Vorrichtung nach Anspruch 1, dadurch gekennzeichnet, daß die Mittel zum Befestigen das Einsetzen und Entfernen einer Batterie (24; 26) in das Gehäuse (14) gestatten.

4. Vorrichtung nach Anspruch 3, dadurch gekennzeichnet, daß die Mittel (100; 74; 76) zum Befestigen das einzelne Einsetzen und Entfernen jeder Batterie (24; 26) gestatten.

5. Vorrichtung nach Anspruch 1, dadurch gekennzeichnet, daß jede Vertiefung (20; 22) eine Lippe (64; 70) aufweist, damit die Batterien (24; 26) über die Lippe (64; 70) in die Vertiefung (20; 22) eingesetzt und entfernt werden können.

6. Vorrichtung nach Anspruch 1, dadurch gekennzeichnet, daß die Klammer (100; 74; 76) einen elektrischen Leiter bildet und eine Klemme der Batterie (24; 26) beim Befestigen der Batterie (24; 26) in der Vertiefung (20; 22) kontaktiert.

7. Verfahren zum Konstruieren einer Vorrichtung zur Verwendung in Verbindung mit einer integrierten Schaltung, die zur Kommunikation mit externen Bauteilen gestaltet ist, mit dem Schritten:
— Schaffen eines Gehäuses mit Mitteln zur Kommunikation zwischen der integrierten Schaltung und externen Bauteilen;
— Befestigen von mindestens einer Batterie in einem an dem Gehäuse befestigten Teil; und
— elektrisches Verbinden der integrierten Schaltung und der Batterie durch elektrische Leitungsmittel;
gekennzeichnet durch die Schritte:
— Unterbringen der integrierten Schaltung in dem Gehäuse;
— Bilden von mindestens einer zur Aufnahme einer Batterie geeigneten Vertiefung in dem Teil; und
— Befestigen von ersten Klammermitteln an dem Teil, die sich im Abstand zu der Vertiefung erstrecken, um eine Batterie in der vertiefung zu befestigen.

8. Verfahren nach Anspruch 7, dadurch gekennzeichnet, daß ein zweites Klammermittel an dem Teil in der Vertiefung befestigt wird, wobei die ersten und zweiten Klammermittel die Klemmen der Batterie berühren, um Strom von der Batterie zu der integrierten Schaltung zu leiten.

9. Verfahren nach Anspruch 7, gekennzeichnet durch Bilden einer Lippe in der Vertiefung des Teils, wobei das erste Klammermittel aus einem flexiblen Material geformt ist, um die Batterie über die Lippe in die Vertiefung einzusetzen und daraus zu entfernen.

10. Verfahren nach Anspruch 7, gekennzeichnet durch die Schritte;
— Anbringen von externen elektrischen Leitungsmitteln an dem Teil, die sich von der Batterie und die integrierten Schaltung erstrekken, um eine Verbindung zu einer externen Spannungsquelle herzustellen; und
— Anbringung von Diodenmitteln an dem Gehäuse, um Stromfluß zu der Batterie zu verhindern, wenn extern Strom zur Versorgung der integrierten Schaltung angelegt wird und um Strom von der Batterie zu der integrierten Schaltung bei einer Entfernung der externen Spannungsquelle fließen zu lassen.

## Revendications

1. Appareil utilisable en coopération avec un circuit intégré adapté pour une communication avec des composants externes, comprenant:
— un boîtier (14) comportant des moyens pour établir une communication entre le circuit intégre (132) et les composants externes;
— des moyens (100; 74; 76) pour fixer une batterie (24; 26) sur ledit boîtier (14); et
— des moyens de conduction électrique s'étendant à partir desdits moyens (100; 74; 76) de fixation sur ledit circuit intégré (132) pour transmettre du courant de la batterie (24; 26) au circuit intégré (132),
caractérisé en ce que ledit boîtier (14) contient ledit circuit intégré (132) et en ce que lesdits moyens (100; 74; 76) de fixation comprennent une structure (12) reliée audit boîtier (14), ladite structure (12) comportant un ou plusieurs évidements (20; 22) adaptés chacun pour recevoir une batterie (24; 26) et des attaches (100; 74; 76) reliées à ladite structure (12) et s'étendant dans une relation espacée jusqu'auxdits évidements (20; 22) pour fixer une batterie (24; 26) dans chaque évidement (20; 22).

2. Appareil selon la revendication 1, caractérisé en ce que lesdits moyens de conduction électrique comprennent deux conducteurs électriques (134) s'étendant jusqu'à des fiches dudit boîtier (14) pour établir une communication avec des composants externes.

3. Appareil selon la revendication 1, caractérisé en ce que lesdits moyens de fixation permettent une mise en place, et un enlèvement, d'une batterie (24; 26) dans ledit boîtier (14).

4. Appareil selon la revendication 3, caractérisé en ce que lesdits moyens de fixation (100; 74; 76) permettent une mise en place individuelle de chaque batterie (24; 26) et son enlèvement.

5. Appareil selon la revendication 1, caractérisé en ce que lesdits évidements (20; 22) comprennent chacun une lévre (64; 70) permettant aux batteries (24; 26) d'être mises en place dans, et enlevées dudit évidement (20; 22) sur la lèvre (64; 70).

6. Appareil selon la revendication 1, caractérisé en ce que lesdits attaches (100; 74; 76) forment un conducteur électrique et entrent en contact avec une borne de la batterie (24; 26) lors d'une fixation de la batterie (24; 26) dans l'évidement (20; 22).

7. Procédé de fabrication d'un appareil utilisable en coopération avec un circuit intégré adapté pour une communication avec des composants externes, comprenant les étapes consistant à:

— former un boîtier comportant des moyens pour établir une communication entre le circuit intégré et des composants externes;

— fixer au moins une batterie dans une structure fixée sur ledit boîtier; et

— assurer l'interconnexion électrique dudit circuit intégré et de ladite batterie par des moyens de conduction électrique;

caractérisé par les étapes consistant à:

— monter ledit circuit intégré dans ledit boîtier;

— former dans ladite structure au moins un évidement adapté pour recevoir une batterie; et

— fixer sur ladite structure une première attache s'étendant dans une relation espacée jusqu'audit évidement pour la fixation d'une batterie dans ledit évidement.

8. Procédé selon la revendication 7, caractérisé en ce qu'il comprend en outre l'étape consistant à fixer une seconde attache sur ladite structure à l'intérieur de l'évidement, lesdites première et seconde attaches entrant en contact avec les bornes de la batterie pour transmettre du courant de la batterie au circuit intégré.

9. Procédé selon la revendication 7, caractérisé en ce qu'il comprend en outre les étapes consistant à former une lèvre dans l'évidement ménagé dans ladite structure, ladite première attache étant formée d'un matériau flexible permettant de mettre en place la batterie dans l'évidement, et de l'enlever de celui-ci, sur la lèvre.

10. Procédé selon la revendication 7, caractérisé en ce qu'il comprend en outre les étapes consistant à:

— monter sur ladite structure des moyens externes de conduction électrique s'étendant à partir de ladite batterie et dudit circuit intégré pour établir une connexion avec une source de courant externe; et

— monter une diode dans ledit boîtier pour empêcher un écoulement de courant vers ladite batterie quand du courant externe est appliqué pour alimenter ledit circuit intégré et pour permettre un passage de courant de ladite batterie jusqu'audit circuit intégré lors d'une coupure du courant externe.

*FIG. 1*

FIG. 1A

FIG. 2

FIG. 3

FIG. 4

0 081 484